# EUROPEAN PATENT APPLICATION

(11) **EP 1 701 382 A1**
(43) Date of publication of application: **13.09.2006**
(21) Application number: 05251425.4
(22) Date of filing: 09.03.2005
(51) Int. Cl.: H01L 23/467, H01L 23/38

(54) **Chip-based CPU cooler and cooling method thereof**

(71) Applicant: ITer Networking Corporation, Jhonghe City, Taipei (TW)
(72) Inventor: Kuo, Wei-Chen, Jhonghe City, Taipei (TW)
(74) Representative: Pratt, David Martin

(57) **Abstract**

Provided are chip-based CPU cooling device and cooling method thereof. The cooling device comprises a metal cover adapted to completely cover and contact the CPU, a hollow seat, a thermal electric cooler shaped to fit in the seat and adapted to contact the cover, a heat dissipation member (e.g., fins) enclosed by a housing and mounted on the seat for contacting the thermal electric cooler, a first fan mounted on top of the housing, and a second fan mounted on side of the housing. An optimum heat dissipation can be obtained by running a control program to control on/off of the fans and power of the thermal electric cooler by operating the cooling device in one of a plurality of corresponding temperature ranges of the CPU.

## Description

### BACKGROUND OF THE INVENTION

### 1. Field of Invention

The present invention generally relates to CPU (central processing unit) cooling devices and more particularly to a chip-based CPU cooling device having a thermal electric cooler and a cooling method thereof.

### 2. Description of Related Art

Operating frequency of the CPU of a computer has been continuously increasing as the technology develops. Accordingly, heat generated by a running CPU increases greatly. Heat dissipation thus has become a critical issue in maintaining the normal operation of a CPU (i.e., computer).

Conventionally, a CPU cooler is implemented as a passive one. In detail, a member formed of high heat conduction metal or alloy is mounted on the CPU. The member comprises a plurality of parallel fins. In operation, heat generated by CPU is transferred to the fins by contact prior to dissipating to the ambient. For achieving maximum heat dissipation, the number of fins, locations of the fins, angles of the fins with respect to CPU, convection, material of the cooler (i.e., heat conductivity of material) are considered. However, the desired good heat dissipation of CPU is compromised as interference among heat conduction, convection, and radiation.

Another conventional CPU cooler is implemented as a thermal electric cooler which is in direct contact with CPU. A heat absorbing surface and a heat dissipating surface are formed on both sides of a semiconductor chip in response to electric current flowing through the thermal electric cooler. The heat absorbing surface contacts the hot CPU and the heat dissipating surface is in fluid communication with a heat sink or cooling fan so as to carry out cooling of the CPU. Such technique is disclosed in Taiwanese Patent No. 88,203,663. However, heat may undesirably transfer back to the heat absorbing surface if cooling members arranged at the heat dissipating surface operate abnormally. Moreover, dew may generate on the cooler due to abrupt temperature drop. Thus, the need for improvement of thermal electric cooler for CPU still exists.

### SUMMARY OF THE INVENTION

It is therefore an object of the present invention to provide a chip-based CPU cooling device having a metal cover completely covered and contacted the CPU for facilitating heat dissipation by eliminating external air interference.

It is another object of the present invention to provide a chip-based CPU cooling device comprising a hollow seat and a housing each having an outer wall, an inner wall, and a groove defined by the walls for directing air communication with a cover or fins by eliminating external air interference.

It is yet another object of the present invention to provide a chip-based CPU cooling device comprising a thermal electric cooler, a first fan mounted on a first outlet, and a second fan mounted on a second outlet such that an optimum heat dissipation can be obtained by running a control program to optionally control on/off of the fans and power of the activated thermal electric cooler depending on actual demand.

In one aspect of the present invention, there is provided a chip-based cooling device mountable on a CPU arranged on a motherboard, comprising a metal cover, a hollow seat, a thermal electric cooler, a heat dissipation member, a housing, a first fan, and a second fan wherein the cover is adapted to completely cover and contact the CPU, the thermal electric cooler is shaped to fit in the seat, the heat dissipation member is enclosed by the housing and is mounted on the seat, the first fan is mounted on top of the housing, the second fan is mounted on one side of the housing, the thermal electric cooler is adapted to contact the cover, and the heat dissipation member is adapted to contact the thermal electric cooler, and wherein the seat and housing each having an outer wall, an inner wall, and a groove defined by the walls for directing air communication with a cover or fin by eliminating external air interference.

In another aspect of the present invention, in a chip-based cooling device mountable on a CPU arranged on a motherboard, the cooling device including a thermal electric cooler including a heat dissipating surface and a heat absorbing surface wherein electricity is produced by heating a junction between the heat absorbing surface and the heat dissipating surface for producing an electromotive force for dissipating heat, a first fan adapted to dissipate heat to the ambient, and a second fan adapted to draw external cold air into the cooling device there is provided a method of cooling the CPU comprising the steps of a) defining an operating temperature of the CPU into one of a plurality of ranges; b) setting a plurality of operations of the first fan, the second fan, and the thermal electric cooler based on each range wherein in a first range each of the thermal electric cooler, the first fan, and the second fan is off; in a second range each of the thermal electric cooler, the first fan, and the second fan is in a standby condition; in a third range the thermal electric cooler operates in low power, the first fan is on, and the second fan is off; in a fourth range the thermal electric cooler operates in high power, the first fan is on, and the second fan is off; in a fifth range the thermal electric cooler operates in high power, the first fan is on, and the second fan is on; and in a sixth range the thermal electric cooler operates in full power, the first fan is on, and the second fan is on; c) measuring the operating temperature of the CPU; and d) running a control program to determine a corresponding one of the ranges that the cooling device is about to perform.

In yet another aspect of the present invention, in a chip-based cooling device mountable on a CPU arranged on a motherboard, the cooling device including a thermal electric cooler including a heat dissipating surface and a heat absorbing surface wherein electricity is produced by heating a junction between the heat absorbing surface and the heat dissipating surface for producing an electromotive force for dissipating heat, a first fan adapted to dissipate heat to the ambient, and a second fan adapted to draw external cold air into the cooling device there is provided a method of cooling the CPU comprising the steps of a) defining an operating temperature of the CPU into one of a plurality of ranges; b) setting a plurality of operations of the first fan, the second fan, and the thermal electric cooler based on each range wherein in a first range the thermal electric cooler operates in low power, the first fan is on, and the second fan is off; in a second range the thermal electric cooler operates in high power, the first fan is on, and the second fan is off; and in a third range the thermal electric cooler operates in high power, the first fan is on, and the second fan is on; c) measuring the operating temperature of the CPU; d) running a control program to determine a corresponding one of the ranges that the cooling device is about to perform; and e) forming a cycle including the first, the second, and the third ranges such that a drop of the operating temperature of the CPU out of the third range is adapted to cause the cooling device to operate in the first range.

The above and other objects, features and advantages of the present invention will become apparent from the following detailed description taken with the accompanying drawings.

### BRIEF DESCRIPTION OF THE DRAWINGS

FIG. 1 is an exploded perspective view of a preferred embodiment of cooling device according to the invention to be mounted on a CPU;
FIG. 2 is a perspective view of one portion of the assembled cooling device shown in FIG. 1;
FIG. 3 is a perspective view of the remaining portion of the assembled cooling device shown in FIG. 1;
FIG. 4 is a perspective view of the completely assembled cooling device on the CPU shown in FIG. 1; and
FIG. 5 is a state diagram illustrating a plurality of temperature cases according to a cooling method of the invention.

### DETAILED DESCRIPTION OF THE INVENTION

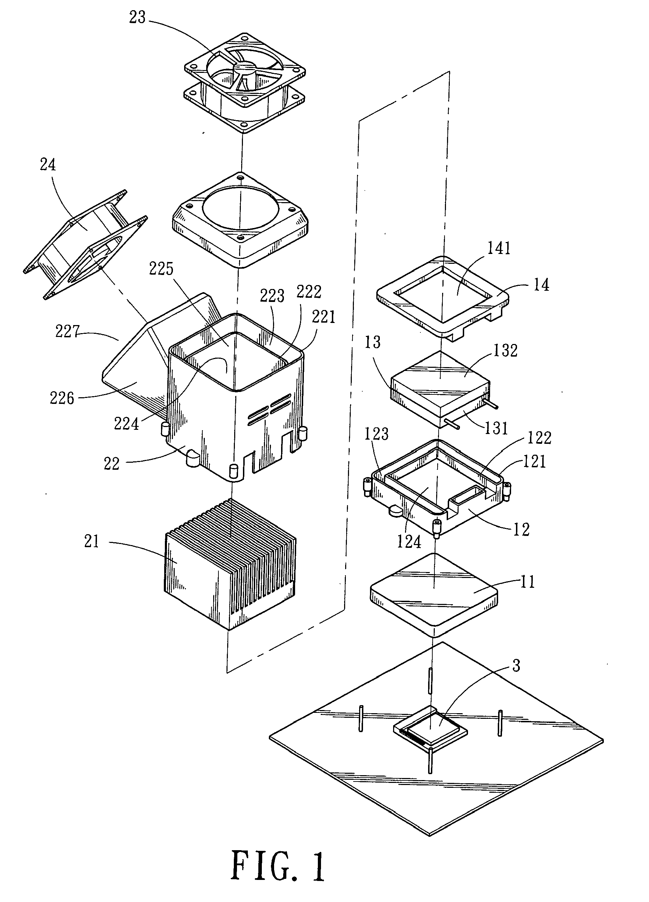

Referring to FIGS. 1 to 4, there is shown a cooling device for CPU in accordance with a preferred embodiment of the invention. The cooling device comprises a cover 11 formed of metal of high heat conductivity, a seat 12, a thermal electric cooler 13, a frame 14, a plurality of fins 21 of high heat conductivity as a heat sink, a housing 22, a first fan 23, and a second fan 24. Each component is discussed in detailed below.

A CPU 3 is completely covered by the cover 11 thereon. The cover 11 also completely contacts the CPU 3 and the thermal electric cooler 13. The cover 11 is served to direct out heat produced from CPU 3. The square hollow seat 12 comprises an outer U-shaped wall 121, an inner U-shaped wall 122, a U-shaped groove 123 defined by the walls 121 and 122 for directing air communication with the cover 11 (i.e., no external air interference), and a central opening 124 which is a hollow-through opening. A chip powered by flowing electric current therethrough is provided in the thermal electric cooler 13 and the chip comprises a lower heat absorbing surface 131 and an upper heat dissipating surface 132. A lower portion of the thermal electric cooler 13 is shaped to neatly fit in the opening 124 to contact the cover 11.

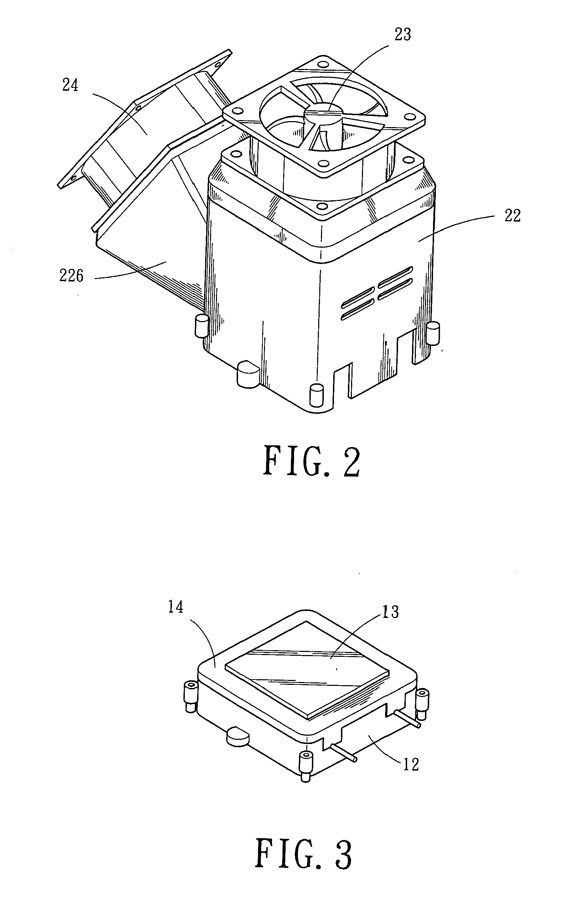

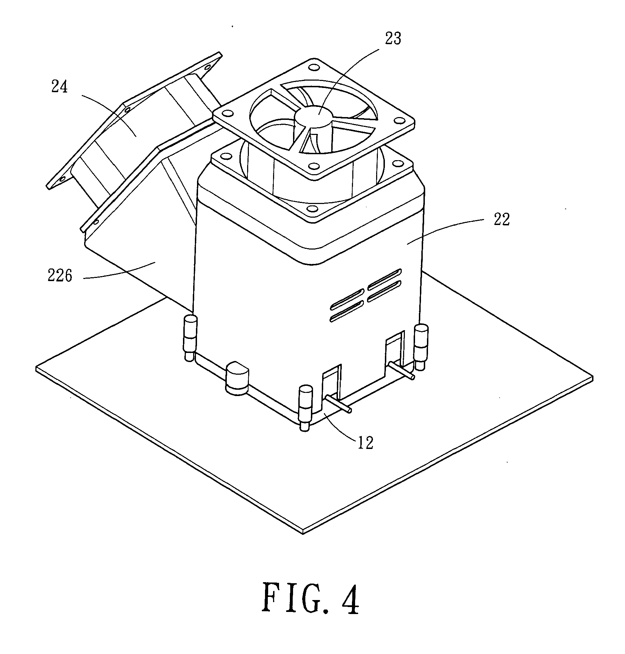

The square frame 14 comprises a central opening 141 with an upper portion of the thermal electric cooler 13 neatly fitted therein and slightly, upwardly projected from the seat 12 (as shown in FIG. 3) to contact the base of the fins 21. The housing 22 is secured to the seat 12 (as shown in FIG. 4), which is in turn secured to a motherboard with the CPU 3 mounted thereon in a manner known in the art. The housing 22, as shown in FIG. 1, comprises an outer wall 221, an inner wall 222, a channel 223 defined by the walls 221 and 222 for directing air communication with the fins 21 (i.e., no external air interference), a central passageway 224 defined by the inner wall 222 for neatly fitting the fins 21 therein, an upper opening 225 with the first fan 23 mounted thereon, and an inclined passage 226 at one side, the passage 226 having an opening 227 at an open end with the second fan 24 mounted thereon. This completes the assembly of the cooling device for CPU on the motherboard, as shown in FIG. 4. Note that the fins 21 may be replaced by any of other good heat dissipation members (e.g., heat pipe) in other embodiments.

In operation, heat generated by the running CPU 3 is transferred to the heat dissipating surface 132 through the cover 11 and the heat absorbing surface 131 by conduction in which electricity is produced by heating the junction between the heat absorbing surface 131 and the heat dissipating surface 132 so as to produce an electromotive force. Further, heat is transferred to the fins 21 from the heat dissipating surface 132 by conduction due to the electromotive force. At the same time, the first fan 23 is powered to dissipate heat from the fins 21 to the ambient via the passageway 224 and the second fan 24 is powered to draw external cold air onto the fins 21 in the passageway 227. Such can greatly enhance the heat dissipation capability of the cooling device, resulting in a quick, sufficient cooling of the CPU 3.

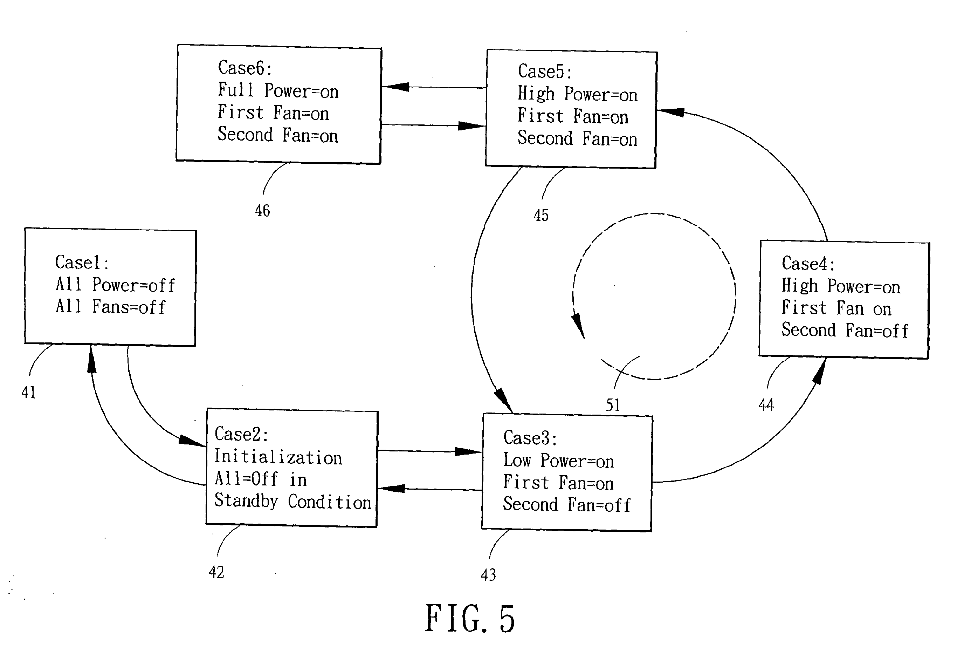

Referring to FIG. 5, it shows a state diagram illustrating a plurality of cases (six cases are shown) according to a cooling method of the cooling device of the invention. The cases are defined based on the operating temperature of CPU 3. A first case 41 corresponds to the operating temperature of CPU 3 smaller than 15□ (i.e., temp<15□), a second case 42 corresponds to the operating temperature of CPU 3 larger or equal to 15□ and smaller than 25□ (i.e., 15□. temp<25□), a third case 43 corresponds to the operating temperature of CPU 3 larger or equal to 250 and smaller than 36□ (i.e., 250. temp<36□), a fourth case 44 corresponds to the operating temperature of CPU 3 larger or equal to 36□ and smaller than 410 (i.e., 360.temp<41 □), a fifth case 45 corresponds to the operating temperature of CPU 3 larger or equal to 410 and smaller or equal to 69.9□ (i.e., 41□.temp.69.9□), and a sixth case 46 corresponds to the operating temperature of CPU 3 larger than 70□ (i.e., 70 □<temp) respectively. Predetermined operations of certain components (e.g., on or off of the first fan 23 and/or the second fan 24, and off, low power operation, or full (or high) power operation of the thermal electric cooler 13 of the cooling device will be activated immediately when the operating temperature of CPU 3 reaches the temperature range of one of the cases. As a result, an optimum heat dissipation effect can be carried out as detailed below.

In the first case 41 the thermal electric cooler 13, the first fan 23, and the second fan 24 are all off. In the second case 42 the thermal electric cooler 13, the first fan 23, and the second fan 24 are in standby condition. In the third case 43 the thermal electric cooler 13 operates in low power (or in half power as in other preferred embodiment), the first fan 23 is on, and the second fan 24 is off. In the fourth case 44 the thermal electric cooler 13 operates in high power, the first fan 23 is on, and the second fan 24 is off. In the fifth case 45 the thermal electric cooler 13 operates in high power, the first fan 23 is on, and the second fan 24 is on. In the sixth case 46 the thermal electric cooler 13 operates in full power, the first fan 23 is on, and the second fan 24 is on.

Additionally, a temperature sensor including a thermometer (not shown) is provided between the cover 11 and the CPU 3. The thermometer is adapted to measure the operating temperature of the CPU 3 and the temperature sensor is adapted to send the measured temperature to a control program which is, in turn, run to determine a corresponding case of the cooling device (i.e., temperature range).

A cycle 51 including third, fourth, and fifth cases 43, 44, and 45 can be formed. For example, a drop of the operating temperature of the CPU 3 out of the range of 41□ and 69.9□ may cause the cooling device to leave the fifth case 45 to enter the third case 43 directly as controlled by the running control program. The cycle 51 thus can operate in a low noise and power saving mode. Moreover, state change can be made either from the first case 41 to the second case 42 or from the second case 42 to the first case 41 (i.e., reversible therebetween). Also, state change can be made either from the second case 42 to the third case 43 or from the third case 43 to the second case 42. In addition, state change can be made either from the fifth case 45 to the sixth case 46 or from the sixth case 46 to the fifth case 45.

Additionally, the operating temperature of CPU 3 and the operating status of any component of the cooling device can be shown on the computer monitor immediately. For instance, an under temperature warning may be issued when the CPU 3 is operating in the first case 41. Also, an over temperature warning may be issued when the CPU 3 is operating in the sixth case 46. In brief, the above temperature cases are implemented as a finite state machine. Further, any change from one state to the other state is done by event driving in a logic flow. For instance, it is done by running a software called "STATE FLOW".

While the invention herein disclosed has been described by means of specific embodiments, numerous modifications and variations could be made thereto by those skilled in the art without departing from the scope and spirit of the invention set forth in the claims.

## Claims

1. A chip-based cooling device mountable on a CPU arranged on a motherboard, comprising a metal cover, a hollow seat, a thermal electric cooler, a heat dissipation member, a housing, a first fan, and a second fan wherein the cover is adapted to completely cover and contact the CPU, the cover is also adapted to contact a bottom of the thermal electric cooler, the thermal electric cooler is shaped to fit in the seat, the housing is mounted on a top of the seat, the heat dissipation member is enclosed by the housing, the first fan is mounted on a top of the housing, the second fan is mounted on a side of the housing, and a bottom of the heat dissipation member is adapted to contact a top of the thermal electric cooler.

2. The cooling device of claim 1, wherein each of the seat and the housing comprises an outer wall, an inner wall, and a groove defined by the walls for direct air communication with the cover or the heat dissipation member.

3. The cooling device of claim 2, wherein the seat further comprises a central opening for receiving the thermal electric cooler.

4. The cooling device of claim 2, wherein the housing further comprises a central passageway defined by the inner wall for receiving the heat dissipation member, an upper opening with the first fan mounted thereon, and an inclined passage at one side, the passage having an opening at an open end with the second fan mounted thereon.

5. The cooling device of claim 4, wherein the first fan is adapted to dissipate heat to the ambient and the second fan is adapted to draw external cold air into the housing.

6. The cooling device of claim 1, further comprising a hollow frame comprising a central opening shaped to put the thermal electric cooler therein such that the thermal electric cooler therein is adapted to upwardly project from the seat.

7. The cooling device of claim 1, wherein the heat dissipation member is a heat sink.

8. The cooling device of claim 1, wherein the heat dissipation member is a heat pipe.

9. In a chip-based cooling device mountable on a CPU arranged on a motherboard, the cooling device including a thermal electric cooler including a heat dissipating surface and a heat absorbing surface wherein electricity is produced by heating a junction between the heat absorbing surface and the heat dissipating surface for producing an electromotive force for dissipating heat, a first fan adapted to dissipate heat to the ambient, and a second fan adapted to draw external cold air into the cooling device, a method of cooling the CPU comprising the steps of:
a) defining an operating temperature of the CPU into one of a plurality of ranges;
b) setting a plurality of operations of the first fan, the second fan, and the thermal electric cooler based on each range wherein in a first range each of the thermal electric cooler, the first fan, and the second fan is off; in a second range each of the thermal electric cooler, the first fan, and the second fan is in a standby condition; In a third range the thermal electric cooler operates in low power, the first fan is on, and the second fan is off; in a fourth range the thermal electric cooler operates in high power, the first fan is on, and the second fan is off; in a fifth range the thermal electric cooler operates in high power, the first fan is on, and the second fan is on; in a sixth range the thermal electric cooler operates in full power, the first fan is on, and the second fan is on;
c) measuring the operating temperature of the CPU; and
d) running a control program to determine a corresponding one of the ranges that the cooling device is about to perform.

10. In a chip-based cooling device mountable on a CPU arranged on a motherboard, the cooling device including a thermal electric cooler including a heat dissipating surface and a heat absorbing surface wherein electricity is produced by heating a junction between the heat absorbing surface and the heat dissipating surface for producing an electromotive force for dissipating heat, a first fan adapted to dissipate heat to the ambient, and a second fan adapted to draw external cold air into the cooling device, a method of cooling the CPU comprising the steps of:
a) defining an operating temperature of the CPU into one of a plurality of ranges;
b) setting a plurality of operations of the first fan, the second fan, and the thermal electric cooler based on each range wherein in a first range the thermal electric cooler operates in low power, the first fan is on, and the second fan is off; in a second range the thermal electric cooler operates in high power, the first fan is on, and the second fan is off; and in a third range the thermal electric cooler operates in high power, the first fan is on, and the second fan is on;
c) measuring the operating temperature of the CPU;
d) running a control program to determine a corresponding one of the ranges that the cooling device is about to perform; and
e) forming a cycle including the first, the second, and the third ranges such that a drop of the operating temperature of the CPU out of the third range is adapted to cause the cooling device to operate in the first range.

11. In a chip-based cooling device mountable on a CPU arranged on a motherboard, a method of cooling the CPU comprising the steps of:
a) defining an operating temperature of the CPU into one of a plurality of ranges;
b) setting a plurality of operations of the first fan, the second fan, and the thermal electric cooler based on each range wherein in a first range the thermal electric cooler operates in low power, the first fan is on, and the second fan is off; in a second range the thermal electric cooler operates in high power, the first fan is on, and the second fan is off; in a third range the thermal electric cooler operates in high power, the first fan is on, and the second fan is on; and in a fourth range the thermal electric cooler operates in full power, the first fan is on, and the second fan is on;
c) measuring the operating temperature of the CPU; and
d) running a control program to determine a corresponding one of the ranges that the cooling device is about to perform.

12. In a chip-based cooling device mountable on a CPU arranged on a motherboard, a method of cooling the CPU comprising the steps of:
a) defining an operating temperature of the CPU into one of a plurality of ranges;
b) setting a plurality of operations of the first fan, the second fan, and the thermal electric cooler based on each range wherein in a first range the thermal electric cooler operates in low power, the first fan is on, and the second fan is off; in a second range the thermal electric cooler operates in high power, the first fan is on, and the second fan is off; and in a third range the thermal electric cooler operates in high power, the first fan is on, and the second fan is on;
c) measuring the operating temperature of the CPU;
d) running a control program to determine a corresponding one of the ranges that the cooling device is about to perform; and
e) forming a cycle including the first, the second, and the third ranges such that a drop of the operating temperature of the CPU out of the third range is adapted to cause the cooling device to operate in the first range.
